(19) Europäisches Patentamt European Patent Office Office européen des brevets

(11) **EP 2 150 981 B1**

(12) **EUROPEAN PATENT SPECIFICATION**

(45) Date of publication and mention of the grant of the patent:
**09.05.2018 Bulletin 2018/19**

(21) Application number: **08766691.3**

(22) Date of filing: **15.05.2008**

(51) Int Cl.:
*H01L 29/06* (2006.01)  *H01L 21/8232* (2006.01)
*H01L 29/78* (2006.01)  *H01L 29/10* (2006.01)

(86) International application number:
**PCT/MY2008/000044**

(87) International publication number:
**WO 2008/147172 (04.12.2008 Gazette 2008/49)**

(54) **MOS TRANSISTOR WITH A P-FIELD IMPLANT OVERLYING EACH END OF A GATE THEREOF**

MOS-TRANSISTOR MIT EINER P-FELD-IMPLANTATION, DIE SICH ÜBER BEIDE ENDEN EINES GATES DES TRANSISTORS ERSTRECKT

TRANSISTOR MOS AVEC IMPLANT DE CHAMP P RECOUVRANT CHAQUE EXTRÉMITÉ D'UNE GRILLE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **29.05.2007 MY 0700840**

(43) Date of publication of application:
**10.02.2010 Bulletin 2010/06**

(73) Proprietor: **X-FAB Semiconductor Foundries AG**
**99097 Erfurt (DE)**

(72) Inventors:
• **KHO, Ching Tee, Elizabeth**
  **Kuching 93350**
  **Sarawak (MY)**
• **TIONG, Mee Guoh, Michael**
  **Kuching 93350**
  **Sarawak (MY)**
• **KEE, Kia, Yaw**
  **Miri 98000**
  **Sarawak (MY)**

• **LI, Wen Jun**
  **Shanghai (CN)**
• **LI, Wenyi**
  **Datong City**
  **Shanxi Province (CN)**
• **MAY, Michael**
  **Kuching 93350**
  **Sarawak (MY)**
• **LIEW, Chean Chian, Alain**
  **Singapore 569786 (SG)**

(74) Representative: **Vidon Brevets & Stratégie**
  **16B, rue de Jouanet**
  **B.P. 90333**
  **Technopole Atalante**
  **35703 Rennes Cedex 7 (FR)**

(56) References cited:
**US-A1- 2001 000 074    US-A1- 2002 053 710**
**US-A1- 2003 049 940    US-A1- 2005 085 045**
**US-A1- 2006 240 627    US-A1- 2006 278 920**
**US-A1- 2007 018 258    US-A1- 2007 029 029**
**US-A1- 2007 057 280    US-B1- 6 274 884**

**Description**

Field of Invention

The present invention relates to the fabrication of MOS transistors. In particular, the invention relates to a method for fabricating high-voltage NMOS transistors with improved characteristics.

Background

High voltage power integrated circuits (IC) devices are growing in demand, such as in flat panel display drivers, power regulators, motor controllers, and so on. These power IC are often integrated with low voltage circuitry on a single chip, for example, using the standard metal-oxide-semiconductor (MOS) technology.

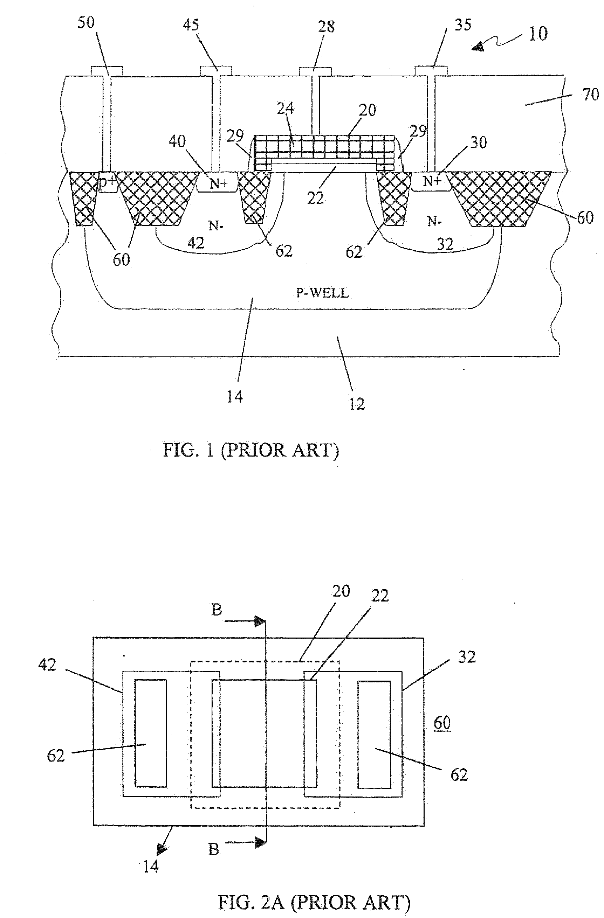

A typical MOS transistor 10 consists of a gate 20, a drain 30 and a source 40. The drain 30 and the source 40 can be n-type or p-type material. FIG. 1 shows the basic structure of the typical high-voltage N-type MOS transistor 10. As the name implies, prior art MOS gate 20 consists of a metal layer built on an oxide layer 22. A recent MOS gate 20 typically consists of a doped polycrystalline silicon (polysilicon) layer 24 built on the oxide layer 22. In modem MOS gate, the polysilicon layer 24 is replaced by high dielectric materials, such as oxides or oxy-nitrides of zirconium, hafnium, aluminium, silicon and so on. As shown in FIG. 1, the high-voltage (HV) NMOS transistor 10 is built in a deep retrograde p-type well 14 formed on a p-type substrate 12. Each HV NMOS transistor 10 is isolated from an adjacent device by a pair of isolators 60. The drain 30 and source 40 regions are typically referred to as "active" regions A of the NMOS transistor 10. Further, as shown in FIG. 1, a body terminal 50 is electrically connected to the p-well 14. In operation, the body 50 and the source 40 are electrically connected to the ground terminal.

The HV NMOS transistor 10 shown in FIG. 1 is of a lateral double-diffused or LD MOS structure, in which the source/drain and gate channel regions are isolated by shallow trench isolators (STI) 62. The drain 30 and source 40 active regions are implanted with n-type material and laterally diffused or drifted into the gate region; the drift implants corresponding to the drain and source regions are labeled drift implants 32, 42. The drain 30, source 40 and gate 20 are then connected by vias for further connection through respective terminals 35, 45 and 28.

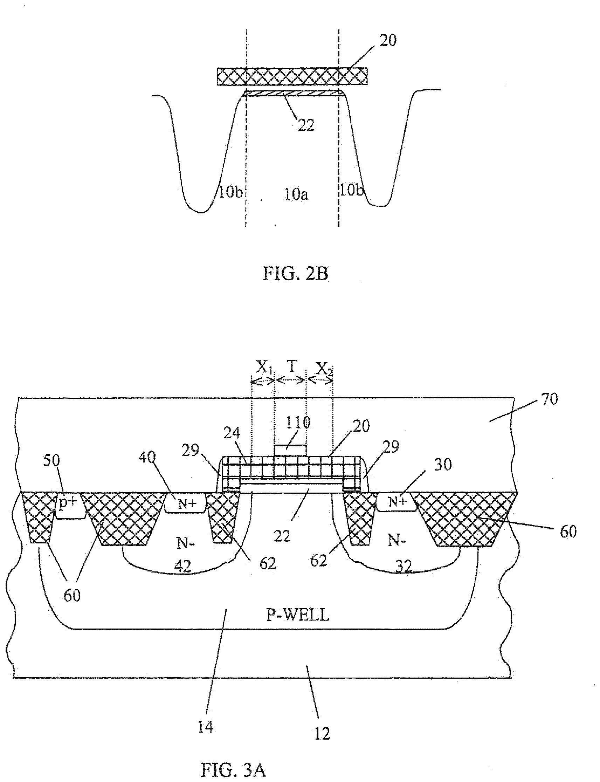

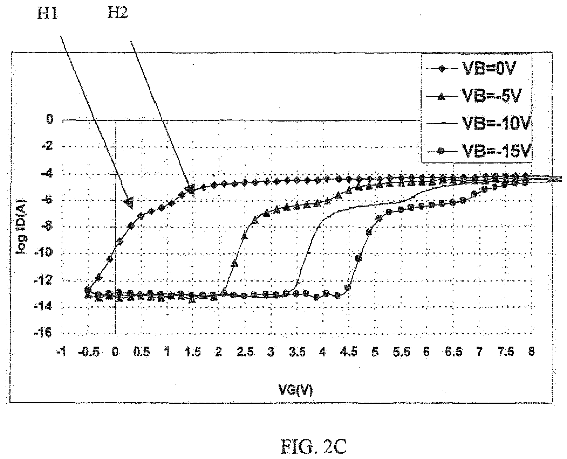

The MOS fabrication techniques rely heavily on masking and etching of materials on a semiconductor wafer. Inherently, the walls of a well or recess created by etching are not entirely vertical. FIG. 2A shows a plan view of an NMOS transistor structure showing two active drift implant regions 32, 42 and a gate 20 therebetween. FIG. 2B shows a sectional view of the transistor 10 along a longitudinal axis BB of the gate 20. As can be seen from FIG. 2B, the gate oxide 22 at the two longitudinal ends of the gate 20 is thinner; this may be due to high mechanical stress at the ends of the gate 20. As a result, the channel concentration at the ends of the gate 20 is lower and the NMOS transistor 10 behaves like an ideal central transistor 10a connected in parallel to an edge transistor 10b. During operation, the edge transistor 10b is turned on at a lower gate voltage than that of the central transistor 10a, that is, the edge transistor 10b has a lower threshold voltage Vt. The different threshold voltages Vt of the edge and main transistor are reflected as humps H1, H2 in the drain current ($I_D$)-gate voltage ($V_G$) characteristic in FIG. 2C. The undesirable edge or parasitic transistor effect creates this so-called double-hump phenomenon. The double hump phenomenon is more significant when the transistor body 50 is negatively biased. As can be seen from FIG. 2C, when the transistor body is more negatively biased, the transfer characteristic is shifted further to the right, thus making the double hump phenomenon more pronounced.

In operation, the double-hump NMOS characteristic results in a small drain leakage current. With power ICs using high voltage NMOS transistors integrated with low-voltage MOS devices, drain leakage current poses a problem, especially for portable electronic equipment running on batteries, which have finite battery power.

The double-hump phenomenon also appears to be caused by other IC fabrication techniques. For example, Cho, et al. in "The Effect of Corner Transistors in STI-isolated SOI MOSFETs", Seoul National University Journal, vol. 28, 2005, discusses the effect of parasitic transistor created at the corners of the gate TEOS sidewalls. A similar subject of discussion is also made by Haneder, et al., "Optimization of Ultra High Density MOS Arrays in 3D", Proceeding of the 27th European, Solid-State Device Research Conference, 22-24 September 1997, pp 268-271.

Document US2007/018258 discloses a high-voltage device structure having a gate longer than the source region and the drain region so as to form spare regions on both sides of the gate.

It can thus be seen that there exists a need for a method for fabricating MOS devices with improved transistor characteristic and lower drain current leakage. In the corollary, the threshold voltage Vt of the edge transistor needs to be increased to suppress the double hump phenomenon.

Summary

The following presents a simplified summary to provide a basic understanding of the present invention. This summary is not an extensive overview of the invention, and is not intended to identify key features of the invention. Rather, it is to present some of the inventive concepts of this invention in a simplified form as a prelude to the detailed description that is to follow.

The present invention provides a method of fabricating according to claim 1. Thus, a transistor fabricated according to the present invention has reduced drain leakage current.

Another embodiment of the method of fabricating is disclosed in claim 2.

Another embodiment of the method of fabricating is disclosed in claim 3.

According to yet another aspect, a transistor fabricated by any of the above methods is provided.

Brief Description of the Drawings

This invention will be described by way of non-limiting embodiments of the present invention, with reference to the accompanying drawings, in which:

FIG.1 illustrates a typical section of a high-voltage n-channel or NMOS transistor fabricated with drift implants;

FIG.2A is a plan view of a typical NMOS transistor structure with drift implants;

FIG. 2B is a sectional view BB along a longitudinal gate dimension of the NMOS transistor structure shown in FIG. 2A; and

FIG. 2C is a typical double-hump transfer characteristic of the NMOS transistor shown in FIG. 2A;

FIG. 3A illustrates a cross-sectional view of a high voltage NMOS transistor structure according to an example;

FIG. 3B illustrates a plan view of the high voltage NMOS transistor structure shown in FIG. 3A;

FIG. 3C illustrates a HV NMOS transistor structure according to an example ;

FIG. 4 illustrates a transfer characteristic of the HV NMOS transistor;

FIG. 5A illustrates a drain current-channel width characteristic of an NMOS transistor without p-field implant, whilst FIG. 5B illustrates a drain current-channel width characteristic of an NMOS transistor;

FIG. 6 is a flow chart illustrating the process steps in fabricating the high voltage NMOS transistor according to the present invention; and

FIG. 7A-7F illustrate cross-sections of the high voltage NMOS transistor formed with a fabrication process according to an embodiment of the present invention, and FIG. 7G illustrates cross-section of the high voltage NMOS transistor formed with a fabrication process according to an example.

Detailed Description

One or more specific and alternative embodiments of the present invention will now be described with reference to the attached drawings. It shall be apparent to one skilled in the art, however that this invention may be practised without such specific details. Some of the details may not be described at length so as not to obscure the invention. For ease of reference, common reference numerals or series of numerals will be used throughout the figures when referring to the same or similar features common to the figures.

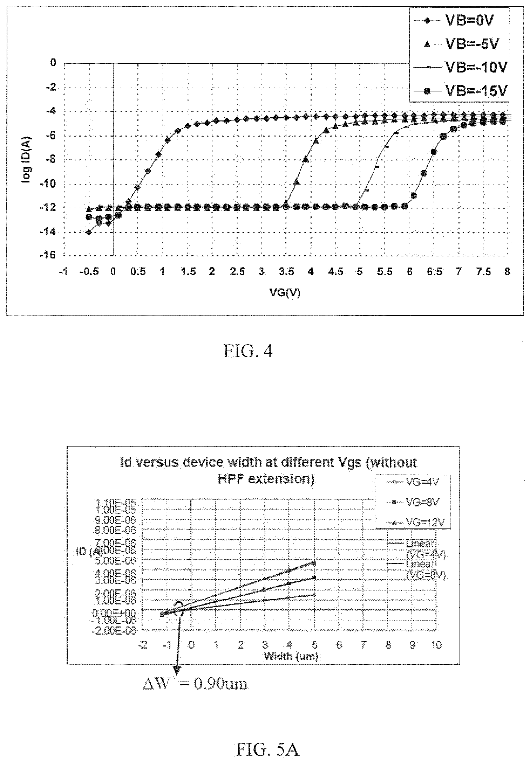

FIG. 3A illustrates an example of a high-voltage (HV) NMOS transistor structure 100. As shown in a cross-sectional view of the gate as in FIG. 3A, the upper part of the deep p-well 14 wall is formed a p-field implanted elongate limb 110 to partially wrap around the end of the gate to overlay each of the two ends of the gate 20. Each elongate limb 110 extends from an upper part of the sidewall 14a of the deep p-well 14 with the elongate limb's longitudinal axis parallel to the longitudinal axis of the gate 20. In a similar manner, the opposite end of the gate 20 has another elongate limb 110 partially extending from the opposite side of the sidewall 14b of the deep p-well 14 and overlying this opposite end of the gate 20. In an example, the width T of the elongate limb 110 ranges from about 0.3 $\mu$m to about 5 $\mu$m. FIG. 4 shows the transfer characteristic of the HV NMOS transistor 100 fabricated according to an example. As can be seen from FIG. 4, there is no double-hump phenomenon in the transfer characteristic of the HV NMOS transistor 100.

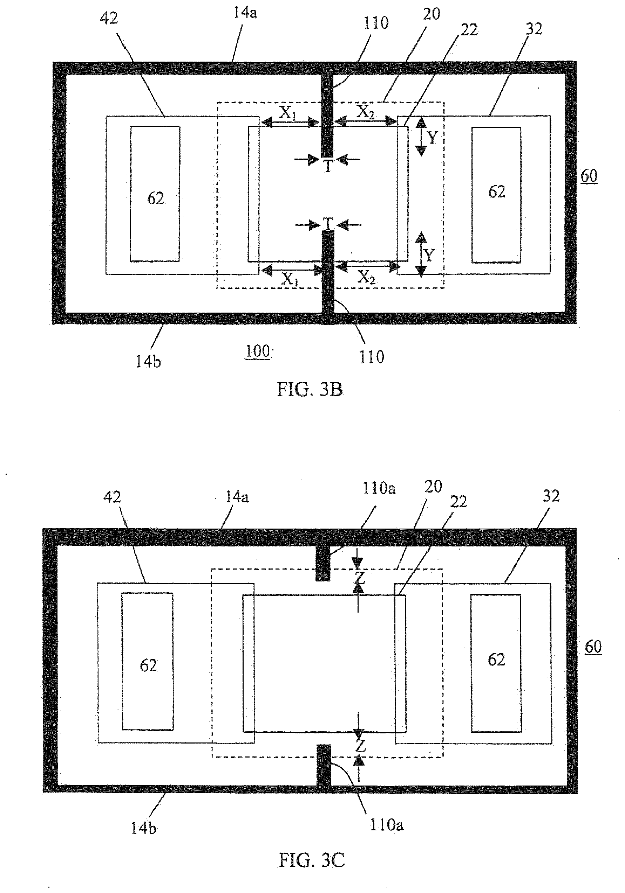

FIG. 3B shows a plan view of the high-voltage NMOS transistor 100 shown in FIG. 3A. As can be seen from FIG. 3B, each elongate limb 110 overlaps the edge of the gate 20 in the longitudinal axis so that the elongate limb 110 is spaced from the source and drain drift implants 32, 42 by respective dimensions X1 and X2; in an example, dimensions X1 and X2 are approximately equal; in another example, X1 and X2 are unequal. As can also be seen, each elongate limb 110 ends at the boundary of the active transistor regions or drift regions 32, 42 or extends into the boundary by dimension Y. In an example, dimension X ranges from 0 to about 5 $\mu$m. In another example, dimension Y ranges from 0 to about 1 $\mu$m. Dimensions X and Y may be varied depending on the concentration of the p-type doping material. In an example, the concentration of the p-field implantation ranges from about $1 \times 10^{12}$ to about $4 \times 10^{14}$ atoms/cm$^2$.

The inventors have found that forming each p-field implanted limb 110 to partially wrap over and overlay each end of the gate 20 advantageously modifies the electric field around each longitudinal end of the gate 20. As a result, the p-field limbs 110 suppress the undesirable effect of the edge transistors and minimize the leakage current that causes the double-hump character.

The threshold voltage Vt can be analysed by the effective gate channel width W. The threshold voltage Vt of the edge or corner transistor corresponding to a wider channel width (W+ $\Delta$W) is given by the following equation:

$$Id \quad = \quad (W + \Delta W) \,.\, \mu \,.\, C_{OX} \,.\, (V_{GS} - Vt) \,.\, V / L_{eff}$$
$$= \quad A \,.\, (W + \Delta W)$$

wherein A is a process constant;
$\Delta$W is the increase in channel width, W;
$\mu$ is the surface mobility of transistor;
$C_{OX}$ is the capacitance per unit area of gate oxide; and
$L_{eff}$ is the effective channel length.

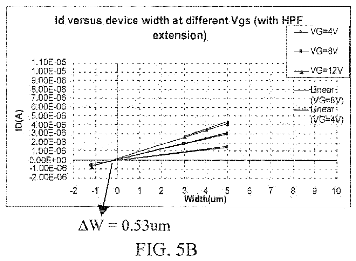

From the above equation, it is noted that the drain current Id is a linear function of the channel width W. By measuring the drain currents Id and plotting them against different channel widths W, the negative x-axis intercept would give a measure of the increase $\Delta$W in channel width. One way of reducing the double hump phenomenon is to reduce the channel width W and increase the channel concentration. FIG. 5A shows the Id-W characteristic for a transistor without p-field implanted limb 110, whilst FIG. 5B shows the Id-W characteristic for a transistor with p-field implanted limbs 110.

FIG. 3C shows an example of high voltage NMOS transistor structure. As shown in FIG. 3C, each elongate limb 110a partially wraps around each longitudinal end of the gate 20 and extends to the boundary of the gate active region or drift regions 32, 42, that is, by a dimension Z. In an example, dimension Z ranges from 0 $\mu$m to about 10 $\mu$m.

In an example, the cross-section of the elongate limbs 110, 110a is quadrilateral or square; in another example, the cross-section of the elongate limb 110, 110a is formed in other shapes. In another example, the cross-sectional area of the elongate limb 110, 110a is non-uniform; the cross-sectional area may be variable, for example, is tapering. In yet another example, the elongate limb 110, 110a is formed with two or more components.

As the source 40 and the body 50 are typically grounded in an NMOS transistor 100, the electric field in the active drain region is high. To modify the high electric field in the gate 20 at the drain side, the elongate limb 110, 110a is offset from the longitudinal axis of the gate 20 towards the drain 30 side, such as for an asymmetric MOS device having only a drain drift region 32 according to the invention.

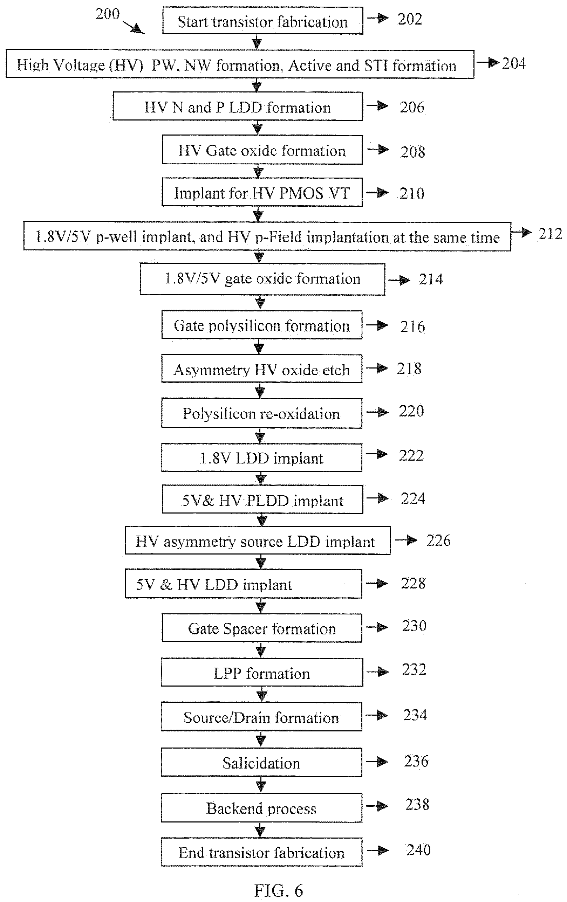

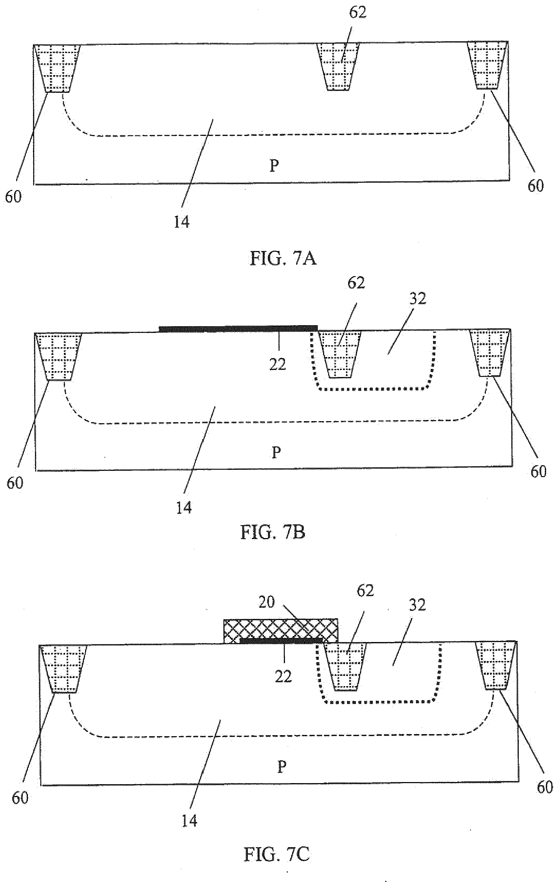

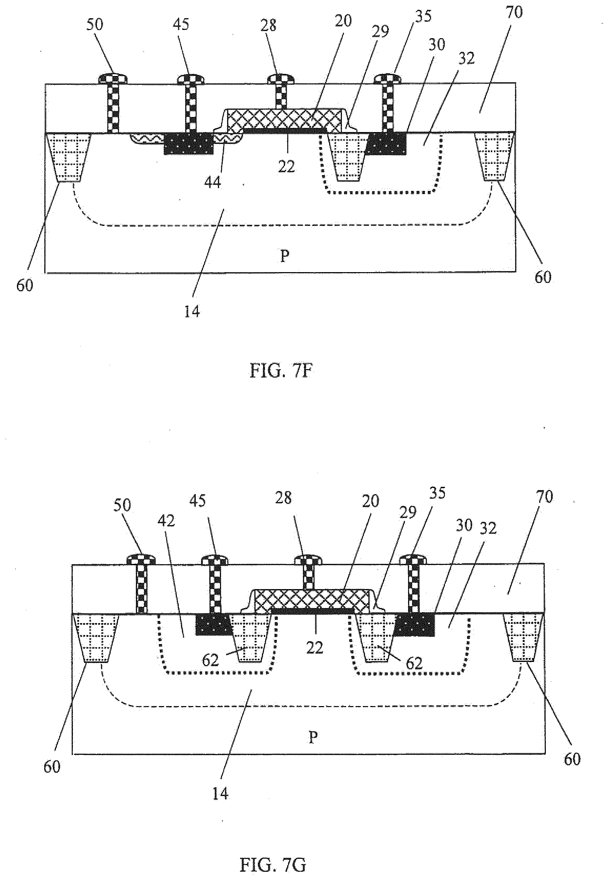

FIG. 6 shows a flow chart illustrating the principal process 200 in the fabrication of a high voltage (HV) NMOS transistor 100 according to the present invention. FIG. 7A-7F illustrate cross-sections of asymmetric HV NMOS transistors 100 formed with the process 200; FIG. 7G illustrates a cross-section of a symmetric HV NMOS transistor formed with the process 200.

As shown in FIG. 6, the fabrication process 200 starts with step 202. In step 202, a p-type substrate 12 is prepared and the fabrication process 200 is initiated. In step 204, the p-well 14 is implanted and heat-treated so that the p-well 14 envelope moves towards the baseline of the substrate. The active area and field area A of the high-voltage NMOS transistor 100 are then defined by isolations 60, such as, shallow trench isolators (STI) or local oxidation of silicon (LOCOS). This partial fabrication of the HV NMOS transistor 100 is shown in FIG. 7A. In step 206, the drain 30 and source 40 regions are implanted with n-type dopants. The n-type dopants are then diffused by employing the Reduced Surface Field (RESURF) technique. The NMOS transistor 100 formed with the RESURF technique has the transistor breakdown region located in the bulk under the gate oxide 22 rather than at the surface, thus allowing higher transistor breakdown voltage at the drain 30. In the next process, i.e. step 208, the partially processed substrate 12 undergoes furnace annealing to form the high-voltage gate oxide 22; partial fabrication of the HV NMOS transistor 100 is now shown in FIG. 7B.

In the next process at step 212, low voltage (LV) (for example, 1.8 and 5 V) implants (such as, anti-punch through, corner transistor Vt adjustment, and so on) and wells are formed for low voltage transistor devices that are complementary to the HV NMOS transistors 100. At the same time, the p-field implantation process for forming the p-field implanted limb 110, 110a is formed with the same masks and implant conditions with such LV p-well implants. The p-field implantation process is common to both the HV and LV devices and there is no additional cost incurred in respect to additional masks and process time. Following this, LV gate oxides are then formed by a thermal oxidation process, in step 214, on the LV devices. Polysilicon 20 is then deposited, patterned and etched, in step 216, to form the gate electrodes for both the HV and LV devices. Asymmetry HV oxide etch is then performed in step 218, followed by a polysilicon re-oxidation process in step 220; partial fabrication of the HV NMOS transistor 100 is now shown in FIG. 7C.

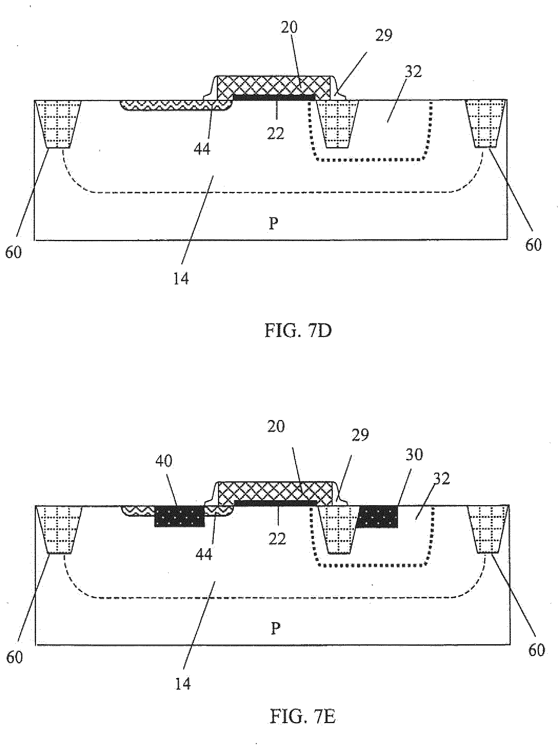

As shown in FIG. 6, the drain and source implantations for HV and LV devices are then performed before forming gate spacers 29 in step 230. For example, in step 222, 1.8V LDD source and drain extension implants are performed for LV devices, followed by 5V LDD source and drain implants for both LV and HV devices in step 224 and HV asymmetry source LDD implant in step 226; these LDD implants are then diffused in a furnace before 5V NMOS LDD implant for both LV and HV devices is carried out in step 228. FIG. 7D illustrates partial fabrication of a HV NMOS transistor 100 after a HV asymmetry drain LDD implant 32, source implant 44 and gate spacer 29 formation.

As shown in FIG. 6, after forming the gate spacers 29 in step 230, drain 30 and source 40 regions for both LV and HV devices are implanted in step 234. The implanted drain/source regions are then self-aligned with respect to the gate spacers 29 in a salicidation process in step 236; the partially formed asymmetric HV NMOS transistor 100 is shown in FIG. 7E. The formed HV NMOS transistor 100 and any complementary LV devices thus formed are then filled with a dielectric 70, such as silicon dioxide. The dielectric 70 is then patterned and etched to form vias to the source, drain and gate regions; these vias are filled with a conductor, such as, metals to form electrical connections 45, 35, 28 to the source, drain and gate. FIG. 7F shows a HV asymmetric NMOS transistor 100 fabricated according to the fabrication process 200; FIG. 7G shows a HV symmetric NMOS transistor 100 fabricated according to process 200.

As shown in FIG. 6, the HV NMOS transistor fabrication is then completed with some backend processes, which are collectively grouped under step 238, before the HV NMOS fabrication process 200 ends in step 240.

In another example of the HV NMOS fabrication process 200, an addition low doped polysilicon (LPP) implantation in step 232 is performed between the gate spacer 29 forming step 230 and the drain/source forming step 234. This LPP implantation provides an additional implant layer to give the polysilicon 20 high resistance.

In another example of the HV NMOS fabrication process 200, the HV asymmetry source LDD implant is integrated with the 5V LDD implant, that is, process steps 226 is integrated into step 224.

While specific embodiments have been described and illustrated, it is understood that many changes, modifications, variations and combinations thereof could be made to the present invention without departing from the scope of the invention. For example, the elongate limb 110 may be formed with a higher concentration of p-type material than the sidewalls of the deep p-well such that the dimensions X, Y and Z can be varied, yet allowing the elongate limbs 110 to advantageously suppress the expression of the edge transistors near the longitudinal ends of the gate 20. Although a high-voltage NMOS structure 100 has been used in the description, a person skilled in the art would appreciate that the principle of this invention can also be applied to suppress leakage currents in PMOS transistors. For example, in fabricating a PMOS transistor, an additional process step 210 is carried after process step 208. In process step 210, the PMOS channel is implanted to adjust the PMOS threshold voltage towards the desired specification. The 5V PMOS LDD implant may then be carried out in process step 224. Whilst specific diffusion techniques have not been described, a skilled person would appreciate that different diffusion techniques, such as lateral double diffusion (LDD) or drift/extended drain (DD) can be incorporated into the present invention.

**Claims**

1. A method of fabricating a high voltage asymmetric MOS transistor with reduced leakage current, wherein said method comprises:

> - forming gate (20), source (40) and drain (30) active regions;
> - forming only a drain drift region (32); and
> - before forming the gate active region, implanting, in an implanted well in which the transistor is to be fabricated, two elongate limbs (110, 110a) having a higher doping concentration than the well, each of said elongate limbs extending, seen in a top view, from the opposite sides of the longitudinal sidewalls of the well, in a direction parallel to the longitudinal axis of the gate active region to partially overlay the two longitudinal ends of the gate active region such that transistor, when in operation, does not exhibit a double-hump transfer characteristic at high gate voltage, with said elongate limbs being offset from the longitudinal axis of the gate (20) active region towards the drain (30) active region,

wherein said longitudinal axis of the gate active region is perpendicular to the direction of the current between said source (40) and drain (30) active regions.

2. The method according to claim 1, wherein said transistor is an NMOS and the field implant region is doped with a p-type material.

3. The method according to claim 1, wherein said field implant region with said limbs is formed along with well implant(s) of a low voltage (LV) MOS transistor.

4. A high voltage asymmetric MOS transistor fabricated according to any one of claims 1 to 3.

**Patentansprüche**

1. Verfahren zum Herstellen eines asymmetrischen Hochspannungs-MOS-Transistors mit reduziertem Leckstrom, wobei das Verfahren umfasst:

- Ausbilden aktiver Gate- (20), Source- (40) und Drain- (30) Gebiete;
- Ausbilden ausschließlich eines Drain-Driftgebiets (32); und
- vor dem Ausbilden des aktiven Gate-Gebiets, Implantieren zweier länglicher Zweige (110, 110a) in einem implantierten Well, in welchem der Transistor herzustellen ist, welche eine höhere Dotierungskonzentration als der Well haben, wobei jeder der länglichen Zweige sich, in einer Draufsicht betrachtet, von den gegenüberliegenden Seiten der longitudinalen Seitenwände des Wells aus in einer zur longitudinalen Achse des aktiven Gate-Gebiets parallelen Richtung erstreckt, um die zwei longitudinalen Enden des aktiven Gate-Gebiets teilweise zu überlagern, so dass der Transistor im Betrieb bei hoher Gate-Spannung keine Doppel-Höcker-Transfercharakteristik aufweist, wobei die länglichen Zweige gegenüber der longitudinalen Achse des aktiven Gate-Gebiets (20) zum aktiven Drain-Gebiet (30) hin versetzt angeordnet sind,

wobei die longitudinale Achse des aktiven Gate-Gebiets senkrecht zur Richtung des Stroms zwischen den aktiven Source- (40) Drain- (30) Gebieten steht.

2. Verfahren nach Anspruch 1, bei dem der Transistor ein NMOS-Transistor ist, und das Feldimplantationsgebiet mit einem p-Typ-Material dotiert ist.

3. Verfahren nach Anspruch 1, bei dem das Feldimplantationsgebiet mit den Zweigen zusammen mit Well-Implantation(en) eines Niederspannungs-(LV) MOS-Transistors ausgebildet wird.

4. Asymmetrischer Hochspannungs-MOS-Transistor, der nach einem der Ansprüche 1 bis 3 hergestellt ist.

**Revendications**

1. Procédé de fabrication d'un transistor MOS asymétrique haute tension avec courant de fuite réduit, dans lequel ledit procédé comprend :

- la formation de régions actives de grille (20), de source (40) et de drain (30) ;
- la formation uniquement d'une région de dérive de drain (32) ; et
- avant la formation de la région active de grille, l'implantation, dans un puits implanté dans lequel le transistor doit être fabriqué, de deux membres allongés (110, 110a) ayant une concentration de dopage plus élevée que le puits, chacun desdits membres allongés s'étendant, dans une vue de dessus, depuis les côtés opposés des parois latérales longitudinales du puits, dans une direction parallèle à l'axe longitudinal de la région active de grille pour recouvrir partiellement les deux extrémités longitudinales de la région active de grille de sorte que le transistor, lorsqu'il est en fonctionnement, ne présente pas de caractéristique de transfert à double bosse à une haute tension de grille, lesdits membres allongés étant décalés de l'axe longitudinal de la région active de grille (20) vers la région active de drain (30),

dans lequel ledit axe longitudinal de la région active de grille est perpendiculaire à la direction du courant entre lesdites régions actives de source (40) et de drain (30).

**2.** Procédé selon la revendication 1, dans lequel ledit transistor est un NMOS et la région d'implant de champ est dopée avec un matériau de type p.

**3.** Procédé selon la revendication 1, dans lequel ladite région d'implant de champ avec lesdits membres est formée avec un ou des implants de puits d'un transistor MOS basse tension (LV).

**4.** Transistor MOS asymétrique haute tension fabriqué selon l'une quelconque des revendications 1 à 3.

FIG. 1 (PRIOR ART)

FIG. 2A (PRIOR ART)

FIG. 2B

FIG. 3A

FIG. 2C

FIG. 3B

FIG. 3C

FIG. 4

$\Delta W = 0.90 \text{um}$

FIG. 5A

FIG. 5B

200 ⟶

Start transistor fabrication ⟶ 202

High Voltage (HV) PW, NW formation, Active and STI formation ⟶ 204

HV N and P LDD formation ⟶ 206

HV Gate oxide formation ⟶ 208

Implant for HV PMOS VT ⟶ 210

1.8V/5V p-well implant, and HV p-Field implantation at the same time ⟶ 212

1.8V/5V gate oxide formation ⟶ 214

Gate polysilicon formation ⟶ 216

Asymmetry HV oxide etch ⟶ 218

Polysilicon re-oxidation ⟶ 220

1.8V LDD implant ⟶ 222

5V& HV PLDD implant ⟶ 224

HV asymmetry source LDD implant ⟶ 226

5V & HV LDD implant ⟶ 228

Gate Spacer formation ⟶ 230

LPP formation ⟶ 232

Source/Drain formation ⟶ 234

Salicidation ⟶ 236

Backend process ⟶ 238

End transistor fabrication ⟶ 240

FIG. 6

FIG. 7A

FIG. 7B

FIG. 7C

FIG. 7D

FIG. 7E

FIG. 7F

FIG. 7G

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007018258 A

**Non-patent literature cited in the description**

- **CHO et al.** The Effect of Corner Transistors in STI-isolated SOI MOSFETs. Seoul National University Journal, 2005, vol. 28

- **HANEDER et al.** Optimization of Ultra High Density MOS Arrays in 3D. *Proceeding of the 27th European, Solid-State Device Research Conference,* 22 September 1997, 268-271